# EUROPÄISCHE PATENTSCHRIFT

(11) **EP 0 422 155 B1**
(45) Veröffentlichungstag und Bekanntmachung des Hinweises auf die Patenterteilung: **07.01.1993**
(21) Anmeldenummer: 90905483.5
(22) Anmeldetag: 06.04.1990
(51) Int. Cl.: G01B 9/02, G01J 9/02, G01B 11/02

(54) **WELLENLÄNGENSTABILISIERUNG, INSBESONDERE FÜR INTERFEROMETRISCHE LÄNGENMESSUNG**
WAVELENGTH STABILIZATION, IN PARTICULAR FOR INTERFEROMETRIC MEASUREMENT OF LENGTH
STABILISATION DE LONGUEUR D'ONDES, NOTAMMENT POUR LONGIMETRIE INTERFEROMETRIQUE

(30) Priorität: 08.04.1989 DE 3911473
(43) Veröffentlichungstag der Anmeldung: 17.04.1991
(73) Patentinhaber: Tabarelli, Werner, Dr., 9494 Schaan (LI)
(72) Erfinder: LEUCHS, Gerhard, CH-9478 Azmoos (CH); KERNER, Martin, CH-3116 Kirchdorf (CH)
(74) Vertreter: Hofinger, Engelbert, DDr.
(86) Internationale Anmeldenummer: EP9000538
(87) Internationale Veröffentlichungsnummer: WO9012279

(56) Entgegenhaltungen:
- EP-A- 0 135 000
- EP-A- 0 290 789
- Feinwerktechnik & Messtechnik, vol. 87, No. 8, November/December 1979, (München, DE), M. Kerner: "Wellenlängenstabilisation", pages 368-372
- Electronique Industrielle, No. 155, 1st February 1989, (Paris, FR), J. Lizet: "Optique intégrée: micro-déplacements et métrologie", pages 38-41
- Optics Letters, vol. 5, No. 5, May 1980, Optical Society of America, (New York, US), S.K. Sheem et al.: "Wavelength monitoring of single-mode diode laser using guided-wave interferometer", pages 179-181

## Beschreibung

Die Erfindung betrifft eine Einrichtung zur Ermittlung oder Stabilisierung der in einem vorzugsweise gasförmigen Umgebungsmedium vorliegenden Wellenlänge von kohärentem Licht aus einer Laserlichtquelle, mit mindestens einer Photodetektoreinheit zur Erfassung einer mit Licht aus der Laserlichtquelle im Umgebungsmedium erzeugten Interferenzerscheinung.

In der interferometrischen Längenmeßtechnik ist die im Umgebungsmedium (meist Luft) vorhandene Wellenlänge der Maßstab für die Messung. Die Wellenlänge (Luftwellenlänge) ändert sich in freier Atmosphäre in Abhängigkeit von der Brechzahl der Luft, welche sich beispielsweise mit der Temperatur, Druck und Feuchte ändert. Interferometer, die Gaslaser (He-Ne) benutzen, sind frequenzstabilisiert, da die Entladungslinie selbst sich als Frequenzreferenz anbietet. Der Einfluß der Brechzahl der Luft wird dort häufig parametrisch (Temperatur, Druck, Feuchte) gemessen, nach der Edlen'schen Formel berechnet und der interferometrische Meßwert damit rechnerisch korrigiert. Bei dieser Methode wird ein Normalluftgemisch vorausgesetzt, das allerdings den heutigen Gegebenheiten in industriellen Räumen nicht mehr entspricht und zu Fehlern führt.

Es ist daher günstiger, die Luftwellenlänge bzw. damit verknüpfte Interferenzerscheinungen direkt (und nicht Frequenz und Brechzahl getrennt) zu erfassen. Es sind bereits derart wellenlängenstabilisierte He-Ne Gaslaser bekannt (CH-Patent 461 114 und CH-Patent 503 285), die allerdings einen kleinen Regelbereich aufweisen und großen Aufwands bedürfen. (Feinwerktechnik und Meßtechnik 87, [1979], 8, pp 368 - 372)

Neben Laserdioden-Interferometern ohne Erfassung der Umweltbedingungen, deren Strahlungsquellen temperatur- und stromstabilisiert sind, deren Frequenz sich jedoch aufgrund von Alterungserscheinungen und Hystereseeffekten ändert (EP-Anmeldung 135 000) sind auch Laserdioden-Interferometer in Wellenleiter-Technologie bekannt, bei denen eine im Umgebungsmedium (Luft) erzeugte Interferenzerscheinung zur Erfassung der Brechzahl der Luft (rechnerische Korrektur) herangezogen wird (DE-OS 37 15 627). Abgesehen von Problemen mit der Auswertung der Interferenzsingale ist dort zur Einkopplung von Licht aus dem luftgefüllten Referenzinterferometer in einen zu den Photodetektoren führenden Lichtwellenleiter ein genau zu justierender Spiegel vorgesehen.

Der Erfindung liegt die Aufgabe zugrunde, eine Einrichtung zur Ermittlung bzw. Erfassung der Luftwellenlänge der eingangs genannten Gattung zu schaffen, die einen einfachen und kompakten optischen Aufbau aufweist und dennoch eine genaue Erfassung bzw. Stabilisierung der Luftwellenlänge ermöglicht.

Dies wird erfindungsgemäß bei einer Einrichtung der eingangs genannten Art dadurch erreicht, daß aus der Laserlichtquelle stammendes Licht von mindestens zwei beabstandeten, im wesentlichen punktförmige Lichtquellen darstellenden Stellen ins Umgebungsmedium gelangt und die von den im wesentlichen punktförmigen Lichtquellen ausgehenden Lichtwellen unter Bildung einer von der/den Photodetektoreinheit(en) erfaßten, räumlichen Interferenzerscheinung im Umgebungsmedium interferieren.

Die von den beabstandeten, im wesentlichen punktförmigen (d.h. Ausdehnung vorzugsweise kleiner als 50 µm, günstigerweise kleiner als 10 µm) Lichtquellen ausgehenden Lichtwellen überlagern sich und interferieren (etwa in der Art einer Young'schen Interferenz).

Diese Interferenzerscheinung ist zunächst statisch und die Interferenzen hängen im wesentlichen nur von der Geometrie der Durchdringung der beiden (bzw. mehreren) Wellen ab. Ändert sich allerdings die Brechzahl des Umgebungsmediums, so ändert sich bei konstanter Frequenz der Laserlichtquelle) auch die Interferenzerscheinung. Zur Detektion der Interferenzerscheinung sind günstigerweise zwei Photodetektoren so angeordnet, daß sich die detektierten Strahlungsintensitäten gegenläufig ändern, wenn sich die Interferenzen verschieben. Dabei ist es wichtig, daß der Abstand zwischen den Detektoren und den quellen konstant und stabil bleibt. Dies kann durch einen einfachen Abstandsring erreicht werden, der aus einem Material besteht, welches weitgehendst unbeeinflußt bleibt von den Parametern (insbesondere der Temperatur), die den Brechungsindex des Umgebungsmediums beeinflussen. Hierfür findet Quarzglas oder Glaskeramik mit einem thermischen Ausdehnungskoeffizienten α = 10⁻⁶ bis 10⁻⁸ K⁻¹ entsprechende Anwendung. Die Genauigkeit der Stabilisierung kann noch dadurch erhöht werden, wenn dieser Abstandsring und der Halter der "Lichtquellen" thermostatisiert wird, entweder gemeinsam mit einer Laserdiode als Lichtquelle, die eine Temperaturregelung zum Einstellen seines Arbeitspunktes benötigt, oder getrennt, wenn die Wellenlängenreferenz in der Nähe der Meßstrecke aufgestellt wird bei der Meßung größerer Entfernungen.

Die von den Photodetektoreinheiten abgegebenen Signale können erfaßt und zur Ermittlung der Luftwellenlänge bzw. bei bekannter Frequenz der Brechzahl herangezogen werden. Diese Ergebnisse können dann beim bevorzugten Einsatz in einem Interferometer zur Längenmessung (dort ist die Kenntnis der Luftwellenlänge von entscheidender Bedeutung) zusammen mit den eigentlichen Meßinterferometerdaten in einem Rechner verarbeitet werden, um den Verschiebeweg oder dgl. in metrischen Einheiten zu erhalten.

Eine bevorzugte Ausführungsform der Erfindung sieht vor, die von den Photodetektoreinheiten abgegebenen Signale zu verwenden, um die Luftwellenlänge (den interferometrischen Maßstab eines Interferometers) konstant zu halten. Es ist dabei vorgesehen, daß die Einrichtung eine elektronische Regeleinrichtung umfaßt, die mit der bzw. den Photodetektoreinheit(en) in Verbindung steht und die die Frequenz der Laserlichtquelle bei Variationen der Brechzahl des Umgebungsmediums derart verändert, daß das räumliche Interferenzmuster und damit die im Umgebungsmedium vorliegende Wellenlänge konstant bleibt.

Bei einer solchen Regelung entfällt vorteilhaft die gesonderte Ermittlung von Frequenz und Brechzahl. Vielmehr wird direkt die entscheidende Größe, nämlich die Luftwellenlänge, konstant gehalten. Eine solche Stabilisierung der Luftwellenlänge ist vor allem bei Laserdioden als Lichtquellen günstig, da diese im allgemeinen ohnehin eine externe Referenz zur Stabilisierung benötigen und sie sich über den Injektionsstrom und/oder die Temperatur verhältnismäßig leicht in ihrer Frequenz verstellen lassen.

Die (Luft) Wellenlängenstabilisation erfolgt beispielsweise durch das Einfangen einer Interferenz zwischen zwei Photodetektoren (oder einer Differentialphotodiode), deren Intensitäten durch einen nachfolgenden Komparator verglichen werden. Dieser Komparator regelt den Injektionsstrom der Laserdiode und damit deren Frequenz derart, daß die räumliche Interferenzerscheinung relativ zu den Photodetektoren örtlich stabil bleibt. Man hat damit eine konstante (Luft) Wellenlänge bei sich ändernder Frequenz in Abhängigkeit der Brechzahl des Umgebungsmediums. Diese Regelung kann aber auch über die Temperatur der Laserdiode erfolgen, was eine gemeinsame Therostatisierung ausschließen würde, wenn deren Temperaturdifferenz größer ist als die der Umgebungstemperatur.

Die erfindungsgemäßen beabstandeten, im wesentlichen punktförmigen Lichtquellen, von denen die interferenzerzeugende Strahlung in die Umgebungsluft austritt, können gemäß einem besonders bevorzugten Merkmal der Erfindung durch die beabstandeten Enden von Lichtwellenleitern gebildet sein, aus denen Licht von der Laserlichtquelle ins Umgebungsmedium austritt. Die Führung von Licht in Lichtwellenleitern an praktisch beliebige Stellen stellt keine Schwierigkeit dar und die die Lichtquellen definierenden Austrittsenden lassen sich leicht und räumlich stabil festlegen.

Es kann vorteilhaft vorgesehen sein, daß die Lichtwellenleiter flexible Lichtleitfasern, vorzugsweise monomode Glasfasern sind, die zumindest in ihrem dem Umgebungsmedium zugewandten Endbereich durch eine Halterung oder dgl. räumlich festgelegt sind. Es ist aber ebenso vorteilhaft möglich, daß die Lichtwellenleiter auf einem Träger(substrat) integrierte Wellenleiter(bahnen) sind, die an beabstandeten Stellen am Rand des Trägers ins Umgebungsmedium münden. Um bei Lichtleitfasern einen die Detektion der Interferenzerscheinung erleichternden Gangunterschied zwischen den Lichtwellen aus den einzelnen Lichtleitfaserenden einzuführen, ist es günstig, wenn die Lichtleitfasern im Endbereich im wesentlichen parallel geführt sind und an - in Faserlängsrichtung gesehen - beabstandeten Stellen enden. Bei integrierten Wellenleiterbahnen kann man zum selben Zweck vorsehen, daß die Wellenleiter(bahnen) unter einem von 90° verschiedenen Winkel schräg auf den Rand des Trägers treffen, wobei die Wellenleiter-Endflächen mit der Randfläche des Trägers in einer Ebene liegen.

Für die erzielte Genauigkeit ist die relative Anordnung von Punktlichtquellen und Photodetektoreinheiten an sich und vor allem die Konstanthaltung dieser relativen Anordnung von entscheidender Bedeutung. Man kann dies durch einen relativ einfachen Abstandhalter erreichen. Dieser trägt einerseits die Photodetektoreinheiten und ist andererseits beispielsweise mit einer Halterung der Glasfaserenden oder dem Trägersubstrat bei integrierten Wellenleiterbahnen verbunden. Besonders stabil scheint ein Abstandsring zu sein, der einen Raum umschließt, in dem die Interferenzerscheinung auftritt. Die Kombination aus Halterung und Abstandsring als Wellenlängenreferenz ist mit geeigneten Durchbrüchen so gestaltet, sodaß das Umgebungsmedium in den Raum ein- und ausströmen kann.

Weitere Vorteile und Einzelheiten der Erfindung werden in der folgenden Figurenbeschreibung näher erläutert.

Es zeigen die Fig. 1 und 2 schematische Darstellungen von Interferometern mit Ausführungsbeispielen einer erfindungsgemäßen Einrichtung zur Wellenlängenstabilisation und die Fig. 3 und 4 weitere Ausführungsbeispiele der erfindungsgemäßen Einrichtung in schematischer Darstellung.

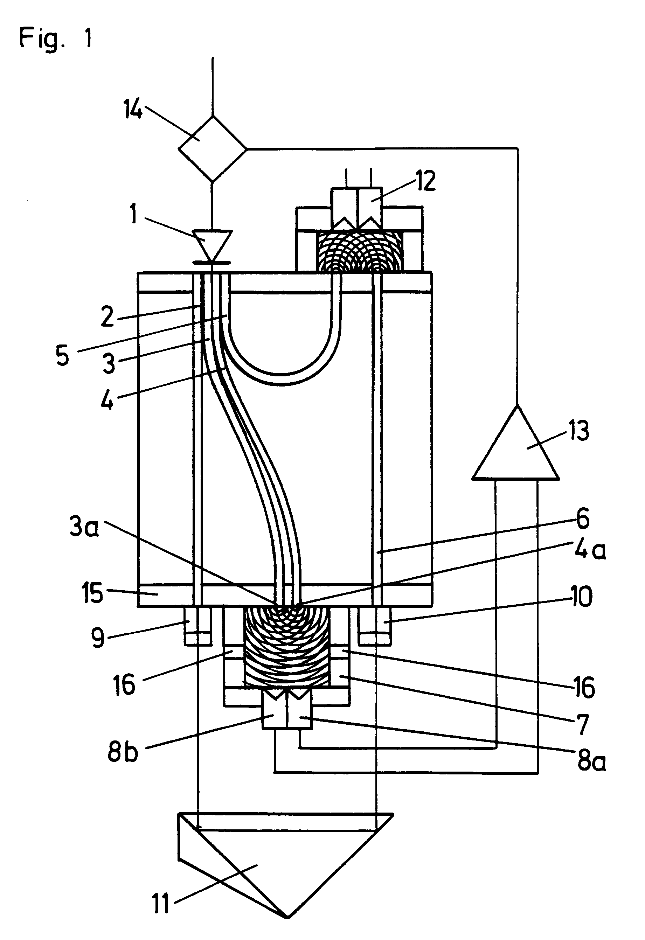

Es zeigt die Fig. 1 die schematische Anordnung eines wellenlängenstabilisierten Längenmessinterferometers, aufgebaut in Glasfaser-Technologie. Die Laserdiode strahlt beispielsweise über nicht dargestellte Einkoppellinsen in die monomoden Fasern 2, 3, 4 und 5. Die Faser 2 leitet den Meßstrahl über das Objekt 9 auf die Meßstrecke im Umgebungsmedium (Luft). Der Tripelspiegel 11 als bewegliches Meßprisma lenkt um und das Objekt 10 koppelt in die Faser 6 ein. Der in der Referenzfaser 5 geführte Referenzstrahl und der in der Faser 6 geführte Meßstrahl erzeugen am Austritt aus den Fasern eine räumliche Interferenzerscheinung, die von den Meßphotodetektoren 12 zur Längenmessung erfaßt wird.

Die erfindungsgemäße Einrichtung zur Stabilisierung der im gasförmigen Umgebungsmedium (Luft) vorliegenden Wellenlänge des von der Laserdiode 1 ausgesandten Lichts weist zwei Lichtleitfasern 3 und 4 (vorzugsweise monomode Glasfasern) auf, die Licht aus der Laserdiode 1 führen und deren Enden 3a und 4a voneinander beabstandete, im wesentlichen punktförmige Lichtquellen bilden. Von den Enden 3a und 4a der beiden Lichtleitfasern, die in einer Halterung 15 gehalten sind, gehen zwei Strahlungskegel aus, die sich im Umgebungsmedium überlagern und dabei zu einer Interferenzerscheinung führen. Der die beiden Photodetektoreinheiten 8a und 8b tragende Abstandsring 7 aus Glaskeramik oder Quarzglas weist Durchtrittsöffnungen 16 auf, die ein Eindringen von Luft in den vom Abstandsring 7 umgrenzten Ring erlauben. Der Abstandsring 7 ist fest mit der Halterung 15 verbunden, beispielsweise verklebt. Die beiden nebeneinanderliegenden Photodetektoreinheiten 8a und 8b können an günstigen Stellen in einem vorgegebenen festen Abstand von den Austrittstellen 3a und 4a aus den Lichtleitfasern 3 und 4 angeordnet sein. Das aus den Photodetektoreinheiten 8a und 8b stammende Signal wird einer Regeleinrichtung 13 zugeführt, die im einfachsten Fall aus einem Komparator besteht. Der Ausgang der Regeleinheit 13 ist mit der die Laserdiode versorgenden Stromquelle 14 verbunden und steuert den Injektionsstrom der Laserdiode und damit die Emissionsfrequenz der Laserdiode derart, daß bei Brechzahländerungen des Umgebungsmediums die detektierte Interferenzerscheinung und damit die Luftwellenlänge konstant bleibt. Selbstverständlich können auch andere Regelparameter, die die Frequenz der Laserdiode 1 beeinflussen, beispielsweise deren Temperatur, von der Regeleinrichtung 13 angesteuert werden. Es ist auch möglich, andere in der Frequenz abstimmbare Laserlichtquellen zu verwenden.

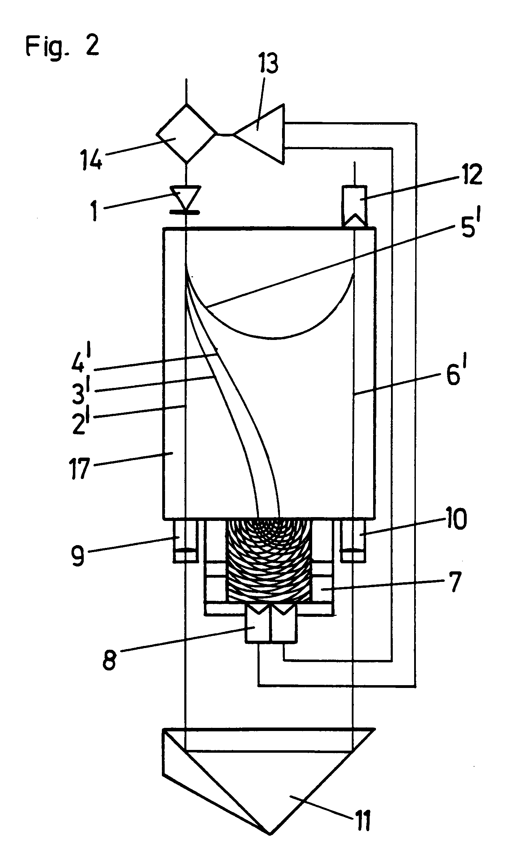

Die Fig. 2 zeigt ebenfalls ein luftwellenlängenstabilisiertes Längenmeßinterferometer, wobei gleiche bzw. äquivalente Teile mit gleichen Bezugzsziffern bezeichnet sind wie in Fig. 1. Der wesentliche Unterschied zu dem in Fig. 1 gezeigten Ausführungsbeispiel besteht darin, daß bei dem in Fig. 2 dargestellten Ausführungsbeispiel die Wellenleiter auf einem Tragersubstrat (beispielsweise Glas oder Lithiumniobat) integrierte Wellenleiterbahnen 2′ bis 6′ sind. Neben einem kompakten Aufbau besteht der Vorteil bei einem solchen in der Technologie der integrierten Optik aufgebauten System darin, daß eine gesonderte Halterung für die Austrittsenden der Wellenleiter 3′ und 4′ entfallen kann. Der Abstandsring 7 kann direkt am Trägersubstrat 17 befestigt, beispielsweise festgeklebt sein.

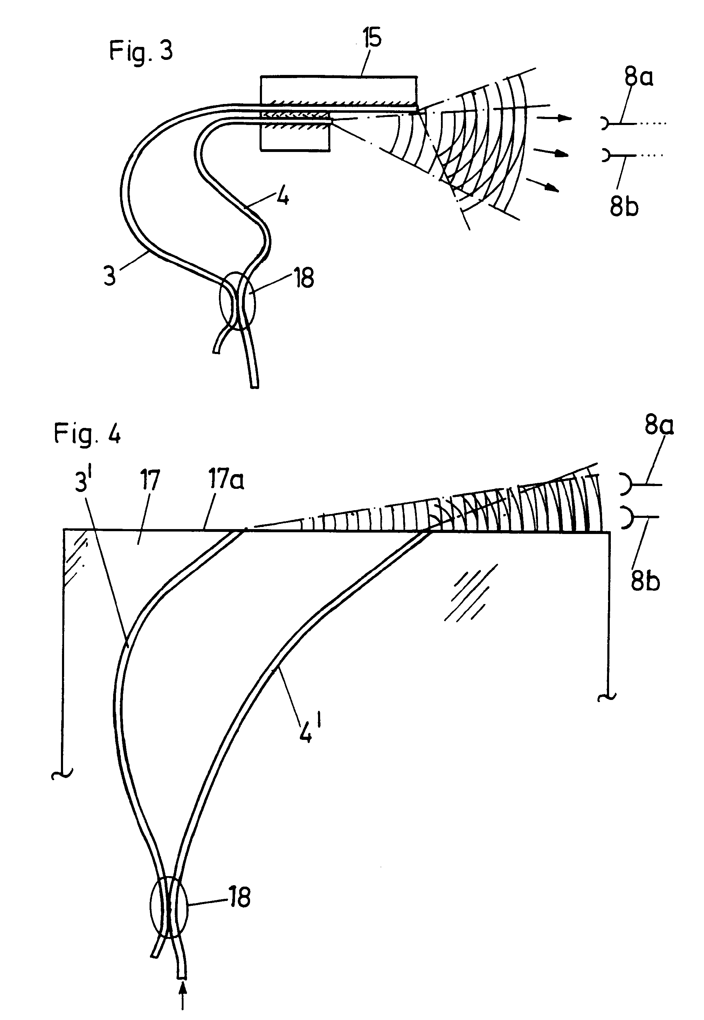

Bei dem in Fig. 3 dargestellten Ausführungsbeispiel gelangt das Licht aus der Laserlichtquelle über einen Strahlteiler (Faserkoppler) 18 in die Lichtleitfasern 3 und 4. Die Endbereiche der Lichtleitfasern sind in der Halterung 15 parallel zueinander geführt, enden jedoch in Faserlängsrichtung gesehen an versetzten Stellen, womit die beiden Photodetektoren 8a und 8b, die über einen nicht dargestellten Abstandhalter räumlich festgelegt sind, höhere Interferenzordnungen empfangen.

Bei dem in Fig. 4 gezeigten Ausführungsbeispiel handelt es sich wiederum um auf einem Trägersubstrat integrierte Wellenleiterbahnen 3′ und 4′, die dort schräg auf die Kante 17a des Trägersubstrats 17 treffen, wobei der Austrittslichtkegel vom Lot weggebrochen wird. Die beiden Photodetektoren 8a und 8b detektieren die räumliche Interferenzerscheinung.

Es kann in der Technologie der integrierten Optik von konstruktivem Vorteil sein, wenn die Interferenzerscheinung durch einen auf dem Abstandsring angebrachten Spiegel (nicht dargestellt) optisch gefaltet wird. Der Abstandsring wird dann um die Hälfte kürzer und die Detektoren oder deren Wellenleiter befinden sich auf der gleichen (Chip-)Seite wie die Quellen.

Grundsätzlich können auch mehr als zwei punktförmige Lichtquellen zur Erzeugung eines räumlichen Interferenzmusters in Luft verwendet werden. Durch das Verfahren zur Stabilisierung der Luftwellenlänge in freier Atmosphäre ist ein Verfahren geschaffen, welches gegenüber der bekannten Frequenzstabilisierung mit nachfolgender parametrischer Messung des Brechungsindexes der Luft und dessen nachträglicher Korrektur wesentlich einfacher im Aufbau und in der Anwendung für die interferometrische Längenmeßtechnik ist.

Das Interferenzverfahren der doppelten (oder mehrfachen) Quellen benötigt keine aufwendigen Kopplungen der Glasfasern und keine Objekte zum Aus- und Einkoppeln der Strahlung in die Luftstrecke. Es ermöglicht die einfache Wellenlängenreferenz in Form eines Abstandshalters, an dessen Form- und Maßgenauigkeit keine hohen Ansprüche gestellt werden müssen (im Gegensatz zu den bekannten Fabry-Pérot Etalons, die ein verspiegeltes Planplattenpaar und einen Abstandsring hoher Genauigkeit aufweisen müssen).

## Patentansprüche

1. Einrichtung zur Ermittlung oder Stabilisierung der in einem vorzugsweise gasförmigen Umgebungsmedium vorliegenden Wellenlänge von kohärentem Licht aus einer Laserlichtquelle (1), mit mindestens einer Photodetektoreinheit (8a,8b) zur Erfassung einer mit Licht aus der Laserlichtquelle (1) im Umgebungsmedium erzeugten Interferenzerscheinung, dadurch gekennzeichnet, daß aus der Laserlichtquelle (1) stammendes Licht von mindestens zwei beabstandeten, im wesentlichen punktförmige Laserlichtquellen darstellenden Stellen (3a,4a) ins Umgebungsmedium gelangt und die von den im wesentlichen punktförmigen Lichtquellen ausgehenden Lichtwellen unter Bildung einer von der/den Photodetektoreinheit(en) (8a,b) erfaßten, räumlichen Interferenzerscheinung im Umgebungsmedium interferieren.

2. Einrichtung nach Anspruch 1, dadurch gekennzeichnet, daß aus der Laserlichtquelle (1) stammendes Licht in mindestens zwei Lichtwellenleitern (3,4;3′,4′) geführt ist, deren ins Umgebungsmedium führende Enden voneinander beabstandet angeordnet sind und die im wesentlichen punktförmigen Lichtquellen bilden.

3. Einrichtung nach Anspruch 2, dadurch gekennzeichnet, daß die Lichtwellenleiter flexible Lichtleitfasern (3,4), vorzugsweise monomode Glasfasern sind, die zumindest in ihrem dem Umgebungsmedium zugewandten Endbereich durch eine Halterung (15) räumlich festgelegt sind.

4. Einrichtung nach Anspruch 3, dadurch gekennzeichnet, daß die Lichtleitfasern (3,4) im Endbereich im wesentlichen parallel geführt sind und an - in Faserlängsrichtung gesehen - beabstandeten Stellen enden.

5. Einrichtung nach Anspruch 2, dadurch gekennzeichnet, daß die Lichtwellenleiter auf einem Träger (17) integrierte Wellenleiter (3′,4′) sind, die an beabstandeten Stellen am Rand des Trägers (17) ins Umgebungsmedium münden.

6. Einrichtung nach Anspruch 5, dadurch gekennzeichnet, daß die Wellenleiter (3′,4′) unter einem von 90° verschiedenen Winkel schräg auf den Rand des Trägers (17) treffen.

7. Einrichtung nach Anspruch 5 oder 6, dadurch gekennzeichnet, daß die Wellenleiter-Endflächen mit der Randfläche des Trägers in einer Ebene liegen.

8. Einrichtung nach einem der Ansprüche 1 bis 7, dadurch gekennzeichnet, daß die Photodetektoreinheit(en) (8a,b) an einem Abstandhalter (7) befestigt sind, der zur Einhaltung eines konstanten Abstandes zwischen den im wesentlichen punktförmigen Lichtquellen und der/den Photodetektoreinheit(en) (8a,8b) dient.

9. Einrichtung nach Anspruch 3 und Anspruch 8, dadurch gekennzeichnet, daß der Abstandhalter (7) mit der Halterung (15) verbunden ist bzw. einstückig mit dieser ausgebildet ist.

10. Einrichtung nach Anspruch 5 und Anspruch 8, dadurch gekennzeichnet, daß der Abstandhalter (7) mit dem Träger (17) verbunden ist.

11. Einrichtung nach einem der Ansprüche 8 bis 10, dadurch gekennzeichnet, daß der vorzugsweise ringförmige Abstandhalter (7) einen Raum umschließt, in dem die Interferenzerscheinung auftritt und der über Öffnungen (16) im Abstandhalter mit der Umgebungsluft kommuniziert.

12. Einrichtung nach einem der Ansprüche 8 bis 11, dadurch gekennzeichnet, daß der Abstandhalter (7) aus einem Material, vorzugsweise Quarzglas oder Glaskeramik, mit einem thermischen Ausdehnungskoeffizienten unter 10⁻⁶K⁻¹ besteht.

13. Einrichtung nach einem der Ansprüche 1 bis 12, dadurch gekennzeichnet, daß zumindest eine Photodetektoreinheit eine Differentialphotodiode ist oder zwei dicht benachbarte Photodioden umfaßt.

14. Einrichtung nach einem der Ansprüche 1 bis 13, dadurch gekennzeichnet, daß die Laserlichtquelle eine Laserdiode (1) ist.

15. Einrichtung nach einem der Ansprüche 1 bis 14, dadurch gekennzeichnet, daß die Interferenzerscheinung beispielsweise über einen Spiegel optisch gefaltet ist und die Photodetektoreinheit(en) vorzugsweise neben den im wesentlichen punktförmigen Lichtquellen liegen.

16. Einrichtung nach einem der Ansprüche 1 bis 14, dadurch gekennzeichnet, daß sie eine elektronische Regeleinrichtung (13) umfaßt, die mit der/den Photodetektoreinheit(en) (8a,b) in Verbindung steht und die die Frequenz der Laserlichtquelle (1) bei Variationen der Brechzahl des Umgebungsmediums derart verändert, daß das räumliche Interferenzmuster und damit die im Umgebungsmedium vorliegende Wellenlänge konstant bleibt.

17. Interferometer zur Längenmessung mit einer Einrichtung zur Erfassung oder Stabilisierung der Wellenlänge von Laserlicht nach einem der Ansprüche 1 bis 16.

18. Interferometer nach Anspruch 17, dadurch gekennzeichnet, daß das über eine konstante Referenzstrecke (5) und das über eine veränderliche Meßstrecke geführte Laserlicht aus der Laserlichtquelle (1) an zwei beabstandeten, im wesentlichen punktförmige Lichtquellen darstellenden Stellen aus jeweils einem Lichtwellenleiter (5,6) austritt und ein räumliches Interferenzmuster erzeugt, das von mindestens einem Meßphotodetektor (12) erfaßt wird.

## Claims

1. A device for determining or stabilizing the wavelength of coherent light from a laser light source (1) found in a preferably gaseous ambient medium, with at least one photo-detector unit (8a,b) to detect interference generated by light from the laser light source (1) in the ambient medium, characterized by the fact that light coming from the laser light source (1) emanates from two spaced locations (3a, 4a), which basically constitute point laser light sources, into the ambient medium and that the light waves emitted by the basically point light sources interfere in the ambient medium forming spatial interference detected by the photo-detector unit(s) (8a,b).

2. The device to Claim 1, characterized by the fact that light coming from the laser light source (1) is guided in at least two light waveguides (3,4; 3′,4′), whose ends leading into the ambient medium are spaced apart and form basically point light sources.

3. The device according to Claim 2, characterized by the fact that the light waveguides are flexible optical fibers (3,4), preferably single-mode glass fibers, which are spatially held by a holder (15), at least at the ends facing the ambient medium.

4. The device according to Claim 3, characterized by the fact that the optical fibers (3,4) are basically parallel at their ends and they end at points spaced from one another, when seen in the longitudinal direction of the fiber.

5. The device according to Claim 2, characterized by the fact that the light waveguides are waveguides (3′,4′) integrated in a carrier (17), which and at spaced points at the edge of the carrier adjacent to the ambient medium.

6. The device according to Claim 5, characterized by the fact that the waveguides (3′,4′) reach the edge of the carrier (17) at an angle different from 90°.

7. The device according to Claim 5 or 6, characterized by the fact that the ends of the waveguide lie in a plane with the surface of the edge of the carrier.

8. The device according to one of Claims 1 to 7, characterized by the fact that the photo-detector unit(s) (8a,b) is (are) attached to a spacer, which is used to keep a constant distance between the basically point light sources and the photo-detector unit(s) (8a,b).

9. The device according to Claims 3 and 8, characterized by the fact that the distance spacer (7) is connected to the holder (15) or is built in a one-piece unit with it.

10. The device according to Claims 5 and 8, characterized by the fact that the spacer (7) is connected to the carrier (17).

11. The device according to one of Claims 8 to 10, characterized by the fact that the spacer, which is preferably ring-shaped (7), encloses a space in which the interference occurs and which communicates with the surrounding air through openings (16) in the spacer.

12. The device according to one of Claims 8 to 11, characterized by the fact that the spacer (7) is made of a material, preferably quartz glass or glass ceramic, with a thermal coefficient of expansion below 10⁻⁶K-¹.

13. The device according to one of Claims 1 to 12, characterized by the fact that at least one photo-detector unit is a differential photo diode or includes two photo diodes that are clossly adjacent.

14. The device according to one of Claims 1 to 13, characterized by the fact that the laser light source is a laser diode (1).

15. The device according to one of Claims 1 to 14, characterized by the fact that the interference is optically folded, e.g. by using a mirror, and the photo-detector unit(s) preferably lie side by side with the basically point light source.

16. The device according to one of Claims 1 to 14, characterized by the fact that it includes an electronik control device (13) which is connected to the photo-detector unit(s) and changes the frequency of the laser light source (1) when there are variations in the refraction index of the ambient medium so that the spatial interference pattern and thus the wavelength in the ambient medium remain constant.

17. An interferometer for length measurement with a device for detecting or stabilizing the wavelength often laser light according to one of Claims 1 to 16.

18. The interferometer according to Claim 17, characterized by the fact that laser light from the laser light source (1) being led over a constant reference distance (5) and over a changing measuring distance emanates from light waveguides (5,6) at two spaced locations basically representing two point light sources and generates a spatial interference pattern, which is detected by at least one measuring photo detector (12).

## Revendications

1. Dispositif pour déterminer ou stabiliser la longueur d'onde, effective dans un milieu ambiant de préférence de forme gazeuse, de la lumière cohérente émanant d'une source de lumière laser (1), dispositif comportant au moins un organe photodétecteur (8a, 8b) pour saisir un phénomène d'interférence produit, dans le milieu ambiant, par la lumière émanant de la source de lumière laser (1), dispositif caractérisé par le fait que la lumière émanant de la source de lumière laser (1) parvient dans le milieu ambiant depuis au moins deux positions (3a, 4a) disposées à distance l'une de l'autre et représentant sensiblement des sources ponctuelles de lumière laser et par le fait que les ondes lumineuses partant des sources lumineuses sensiblement ponctuelles interfèrent dans le milieu ambiant en donnant lieu à un phénomène d'interférence spatial, saisi par l'organe photodétecteur ou par les organes photodétecteurs (8a, 8b).

2. Dispositif selon la revendication 1, caractérisé par le fait que la lumière émanant de la source de lumière laser (1) passe dans au moins deux guides d'ondes lumineuses (3, 4; 3′, 4′) dont les extrémités parvenant dans le milieu ambiant sont disposées à distance l'une de l'autre et qui forment les sources lumineuses sensiblement ponctuelles.

3. Dispositif selon la revendication 2, caractérisé par le fait que les guides d'ondes lumineuses sont des fibres optiques flexibles (3, 4), de préférence des fibres de verre monomodes, qui, tout au moins dans leur zone d'extrémité orientée vers le milieu ambiant, sont fixées dans l'espace par un soutien (15).

4. Dispositif selon la revendication 3, caractérisé par le fait que les fibres optiques (3, 4) sont, dans la zone d'extrémité, sensiblement parallèles et se terminent en des positions disposées à distance l'une de l'autre - vu dans la direction de la longueur des fibres.

5. Dispositif selon la revendication 2, caractérisé par le fait que les guides d'ondes lumineuses sont des guides d'ondes (3′, 4′) qui sont intégrés sur un support (17) et qui débouchent dans le milieu ambiant en des positions disposées à distance l'une de l'autre au bord du support (17).

6. Dispositif selon la revendication 5, caractérisé par le fait que les guides d'ondes (3′, 4′) tombent obliquement sur le bord du support (17) sous un angle différent de 90°.

7. Dispositif selon la revendication 5 ou 6, caractérisé par le fait que les surfaces d'extrémité des guides d'ondes sont dans le plan de la surface de bordure du support.

8. Dispositif selon l'une des revendications 1 à 7, caractérisé par le fait que l'organe photodétecteur, ou les organes photodétecteurs (8a,b) sont fixés sur un écarteur (7) qui sert à maintenir un écart constant entre les sources lumineuses sensiblement ponctuelles et l'organe photodétecteur, ou les organes photodétecteurs (8a,b).

9. Dispositif selon la revendication 3 et la revendication 8, caractérisé par le fait que l'écarteur (7) est lié au soutien (15) ou est conçu d'une pièce avec celui-ci.

10. Dispositif selon la revendication 5 et la revendication 8, caractérisé par le fait que l'écarteur (7) est lié au support (17).

11. Dispositif selon l'une des revendications 8 à 10, caractérisé par le fait que l'écarteur (7), de préférence de forme annulaire, enclôt un espace dans lequel se produit le phénomène d'interférence et qui communique avec l'air ambiant par des ouvertures (16) prévues dans l'écarteur.

12. Dispositif selon l'une des revendications 8 à 11, caractérisé par le fait que l'écarteur (7) est constitué d'un matériau, de préférence du verre de quartz ou de la céramique de verre, d'un coefficient de dilatation thermique inférieur à 10⁻⁶K⁻¹.

13. Dispositif selon l'une des revendications 1 à 12, caractérisé par le fait qu'au moins un organe photodétecteur est une photodiode différentielle ou comporte deux photodiodes très voisines.

14. Dispositif selon l'une des revendications 1 à 13, caractérisé par le fait que la source de lumière laser est une diode laser (1).

15. Dispositif selon l'une des revendications 1 à 14, caractérisé par le fait que le phénomène d'interférence est rabattu optiquement par exemple au moyen d'un miroir et par le fait que l'organe photodétecteur, ou les organes photodétecteurs, se trouve, ou se trouvent, de préférence à côté des sources de lumière sensiblement ponctuelles.

16. Dispositif selon l'une des revendications 1 à 14, caractérisé par le fait qu'il comporte un mécanisme de régulation électronique qui est relié à l'organe photodétecteur, ou aux organes photodétecteurs (8a,b), et qui, en cas de variations de l'indice de réfraction du milieu ambiant, modifie la fréquence de la source de lumière laser (1) de façon telle que le modèle d'interférence spatiale et donc la longueur d'onde effective dans le milieu ambiant, restent constants.

17. Interféromètre pour la mesure de longueurs, comportant un dispositif pour saisir ou stabiliser la longueur d'onde d'une lumière laser selon l'une des revendications 1 à 16.

18. Interféromètre selon la revendication 17, caractérisé par le fait que la lumière laser émanant de la source de lumière laser (1) et passant par un chemin de référence constant (5) et celle passant par un chemin de mesure variable apparaissent, en sortant chacune d'un guide d'ondes lumineuses (5, 6), en deux positions disposées à distance l'une de l'autre et représentant sensiblement des sources lumineuses ponctuelles, et produisent un modèle d'interférence spatiale qui est saisi par au moins un photodétecteur de mesure (12).
